# EUROPEAN PATENT APPLICATION

(11) **EP 4 372 988 A1**
(43) Date of publication of application: **22.05.2024**
(21) Application number: 22940965.1
(22) Date of filing: 30.11.2022
(51) Int. Cl.: H03H 9/02, H03H 9/54

(54) **RESONATOR, RESONATOR ASSEMBLY, FILTER, ELECTRONIC DEVICE, AND MANUFACTURING METHOD**

(30) Priority: 30.09.2022 CN 202211230473
(71) Applicant: JWL (Zhejiang) Semiconductor Co., Ltd., Huzhou, Zhejiang 313000 (CN)
(72) Inventor: LI, Linping, Huzhou, Zhejiang 313000 (CN)
(74) Representative: Kolster Oy Ab
(86) International application number: PCT/CN2022/135593
(87) International publication number: WO 2024/066021

(57) **Abstract**

A resonator, a resonator assembly, a filter, an electronic device, and a method for manufacturing the resonator. The resonator comprises: a substrate, comprising a first surface and a second surface opposite to each other; a first electrode, located on the first surface, where the first electrode comprises a first protruding portion protruding away from the first surface and a first flat portion attached on the first surface, and a cavity is formed between the first protruding portion and the first surface; a piezoelectric layer, located at a side of the first electrode away from the substrate, where the piezoelectric layer extends in parallel with the first surface; and a second electrode, located at a side of the piezoelectric layer away from the first electrode. Since the piezoelectric layer extends in parallel with the first surface, the variation of stress is small throughout the entire piezoelectric layer, which ensures consistency of a piezoelectric performance of the piezoelectric layer. The piezoelectric layer having small deformation renders a mechanical structure stable, and is less likely break under an external impact.

## Description

This application claims priority to Chinese Patent Application No. 202211230473.1, titled "RESONATOR, RESONATOR ASSEMBLY, FILTER, ELECTRONIC DEVICE AND METHOD FOR MANUFACTURING THE SAME", filed on September 30, 2022 with the China National Intellectual Property Administration, which is incorporated herein by reference in its entirety.

### FIELD

The present disclosure relates to the technical field of semiconductors, and in particular to a resonator, a resonator assembly, a filter, an electronic device and a method for manufacturing the resonator.

### BACKGROUND

The electromagnetic spectrum becomes increasingly crowded, and wireless communication devices are provided with more and more frequency bands and functions. The electromagnetic spectrum for wireless communications is expanding rapidly from 500MHz to 5GHz and even higher, and consequently there is an increasing demand for radio-frequency (RF) front-end modules having high performances, low costs, low power consumption, and a small dimension. A filter is one of the RF front-end modules, is capable of improving quality of signals that are transmitted and received, and hence has an indispensable role in the RF front-end module.

In conventional technology, a resonator is manufactured through stacking a substrate, a first electrode, a piezoelectric layer, and a second electrode in the above-listed sequence. The first electrode has a protruding structure, and the protruding structure and the substrate form a cavity. The piezoelectric layer is stacked directly on a surface of the first electrode. Hence, the piezoelectric layer is subject to a large morphological change at an edge of the cavity, hence is subject to a large quantity of growth defects at such region. Moreover, piezoelectric layer is subject to a large stress in such region, which results in a variation of stress throughout a whole wafer and hence lowers a yield of devices. In addition, a mechanical structure of the devices has poor stability under a thermal shock.

In the resonator, propagation of acoustic waves is dominated by a longitudinal mode, and further has undesirable transverse modes. Such transverse modes result in a loss in acoustic energy and decrease a Q factor of the devices. Hence, it is necessary to reduce or suppress the transverse modes in order to improve the Q factor. As an approach, the acoustic waves in the transverse modes (i.e., transverse waves) are reflected back into the device at a boundary of a resonant region of the device, and a part of the transverse waves is converted into longitudinal waves.

### SUMMARY

In view of the above, following solutions are provided. In a first aspect, a resonator is provided according to embodiments of the present disclosure

The resonator comprises: a substrate, comprising a first surface and a second surface opposite to each other; a first electrode, located on the first surface, where the first electrode comprises a first protruding portion protruding away from the first surface and a first flat portion attached on the first surface, and a cavity is formed between the first protruding portion and the first surface; a piezoelectric layer, located at a side of the first electrode away from the substrate, where the piezoelectric layer extends in parallel with the first surface; and a second electrode, located at a side of the piezoelectric layer away from the first electrode.

In an embodiment, a first gap is formed between the first flat portion and the piezoelectric layer.

In an embodiment, the first gap comprises an air gap, or the first gap is filled with a dielectric material.

In an embodiment, a side of the first flat portion away from the first protruding portion is physically connected to a supporting structure, and an upper surface of the supporting structure and an upper surface of the first protruding portion are in a same plane.

In an embodiment, the supporting structure comprises a second protruding portion protruding away from the first surface and a second flat portion attached on the first surface.

In an embodiment, the supporting structure is made of a conductive material or a non-conductive material.

In an embodiment, a second gap is formed between the second protruding portion and the first surface.

In an embodiment, a dielectric material filled in the second gap comprises one or both of: air, and a dielectric having low acoustic impedance.

In a second aspect, a resonator assembly is provided according to embodiments of the present disclosure. The resonator assembly comprises a resonator and another resonator that are connected, where the resonator and the other resonator each is the resonator according to any foregoing embodiments.

In an embodiment, a third gap is formed between a portion of the piezoelectric layer, which is in a connection region between the resonator and the other resonator, and one or both of: the first electrode and the first surface.

In an embodiment, the third gap comprises an air gap or is filled with a dielectric material.

In an embodiment, a release hole is provided at each of: the piezoelectric layer at the portion above the third gap, and the first electrode at a portion between the first protruding portion and the first flat portion, where the release hole is configured to inject an etching reagent to form the third gap or the cavity.

In an embodiment, the first electrode of the resonator and the first electrode of the other resonator are connected to each other; the second electrode of the at least one resonator and the second electrode of the other resonator are connected; or the first electrode of the at least one resonator and the second electrode of the other resonator are connected.

In an embodiment, the first electrode of the resonator and the first electrode of the other resonator are connected via the supporting structure, or the second electrode of the resonator is connected to the first electrode of the other resonator via the supporting structure.

In an embodiment, the second electrode of the resonator is connected to the first electrode of the other resonator via a hole running through the piezoelectric layer of the other resonator.

In an embodiment, a terminal for external connection, for one or both of the first electrode and the second electrode of the resonator, is connected to a bonding pad, a capacitor, or an inductor via the supporting structure.

In a third aspect, a filter is provided according to embodiments of the present disclosure. The filter comprises the resonator according to any foregoing embodiment.

In a fourth aspect, an electronic device is provided according to embodiments of the present disclosure. The electronic device comprises the resonator according to any foregoing embodiment.

In a fifth aspect, a method for manufacturing a resonator is provided according to embodiments of the present disclosure. The method comprises: providing a substrate, which comprises a first surface and a second surface opposite to each other; forming a first electrode which is on the first surface, where the first electrode comprises a first protruding portion protruding away from the first surface and a first flat portion attached on the first surface, and a cavity is formed between the first protruding portion and the first surface; forming a piezoelectric layer which is at a side of the first electrode away from the substrate, wherein the piezoelectric layer extends in parallel with the first surface; and forming a second electrode which is at a side of the piezoelectric layer away from the first electrode.

In an embodiment, the method further comprises: forming a first sacrificial layer in a region in which the cavity is to be formed, and removing the first sacrificial layer after forming the second electrode to form the cavity.

In an embodiment, a first gap is formed between the first flat portion of the first electrode and the piezoelectric layer.

In an embodiment, the method further comprises: forming a second sacrificial layer in a region in which the first gap is to be formed, and removing the second sacrificial layer after forming the second electrode, to form the first gap; or forming a dielectric layer in the region in which the first gap is to be formed to form the first gap.

In an embodiment, before forming the piezoelectric layer, the method further comprises: forming a supporting structure at a side of the first flat portion away from the first protruding portion, where the supporting structure comprises a second protruding portion protruding away from the first surface and a second flat portion attached on the first surface, and an upper surface of the second protruding portion and an upper surface of the first protruding portion are in a same plane.

In an embodiment, a second gap is formed between the second protruding portion and the first surface. Forming the supporting structure comprises: forming a third sacrificial layer in a region in which the second gap is to be formed; forming the supporting structure on the third sacrificial layer; and removing the third sacrificial layer after forming the second electrode. Alternatively, forming the supporting structure comprises: forming a dielectric layer in a region in which the second gap is to be formed; and forming the supporting structure on the dielectric layer.

In an embodiment, the supporting structure and the first electrode are simultaneously formed as a same layer or from a same layer.

As described above, the resonator is provided according to technical solutions of the present disclosure. The piezoelectric layer is parallel or substantially parallel to the first surface of the substrate, and hence local deformation in the piezoelectric layer is small. Thereby, the whole piezoelectric layer is subject to few growth defects and little variation in stress, which leads to excellent consistency in a piezoelectric performance throughout the piezoelectric layer. In addition, small deformation of the entire piezoelectric layer leads to a stable mechanical structure, and the piezoelectric layer is robust under an external impact.

### BRIEF DESCRIPTION OF THE DRAWINGS

For clearer illustration of the technical solutions according to embodiments of the present disclosure or conventional techniques, hereinafter are briefly described the drawings to be applied in embodiments of the present disclosure or conventional techniques. Apparently, the drawings in the following descriptions are only some embodiments of the present disclosure, and other drawings may be obtained by those ordinary skilled in the art based on the provided drawings without creative efforts.

Structures, proportions, dimensions, and the like shown in the drawing are only intended for facilitating understanding and reading of those skilled in the art in conjunction with what is disclosed in the specification, rather than limiting a condition for implementing the present disclosure, and hence are not actual technical specifics. Any modification on the structures, variation of the proportions, or adjustment of the dimensions shall still fall within the scope of technical content disclosed in the present disclosure, as long as it does not affect an effect and a purpose of the present disclosure.
Figure 1 is a schematic structural diagram of a resonator in conventional technology.
Figure 2 is a schematic structural diagram of a resonator according to an embodiment of the present disclosure.
Figure 3 to Figure5 are graphs of impedance of a resonator versus a frequency according to an embodiment of the present disclosure.
Figure 6 is a graph of a resonant frequency of parallel resonators according to an embodiment of the present disclosure.
Figure 7 is a schematic structural diagram of a resonator according to another embodiment of the present disclosure.
Figure 8 is a schematic structural diagram of a resonator assembly according to an embodiment of the present disclosure.
Figure 9 is a schematic structural diagram of a resonator assembly according to another embodiment of the present disclosure.
Figure 10 is a schematic structural diagram of a resonator assembly according to another embodiment of the present disclosure.
Figure 11 is a schematic structural diagram of a resonator assembly according to another embodiment of the present disclosure.
Figure 12 is a schematic structural diagram of a resonator assembly according to another embodiment of the present disclosure.
Figure 13 is a schematic structural diagram of a resonator assembly according to another embodiment of the present disclosure.
Figure 14 is a schematic structural diagram of a resonator assembly according to another embodiment of the present disclosure.
Figure 15 to Figure 21 are schematic diagrams of a process for manufacturing a resonator according to an embodiment of the present disclosure.

### DETAILED DESCRIPTION OF EMBODIMENTS

Hereinafter the technical solutions in the embodiments of the present disclosure are described clearly and thoroughly in conjunction with the accompanying drawings in the embodiments of the present disclosure. Apparently, the described embodiments are only some rather than all of the embodiments of the present disclosure. Any other embodiments obtained based on the embodiments of the present disclosure by those ordinary skilled in the art without any creative effort fall within the scope of protection of the present disclosure.

A cavity of the resonator mainly includes a cavity embedded in a substrate and a cavity located on a surface of the substrate. When fabricating the cavity embedded in the substrate, it is necessary to etch a substrate to form a groove and then form the cavity at a position of the groove. Etching the substrate to form a large groove consumes a long time, which increases time consumption of manufacturing significantly. In comparison, it is not necessary to etch the substrate when fabricating the cavity located on the surface of the substrate. Hence, time consumption of forming the cavity can be reduced significantly.

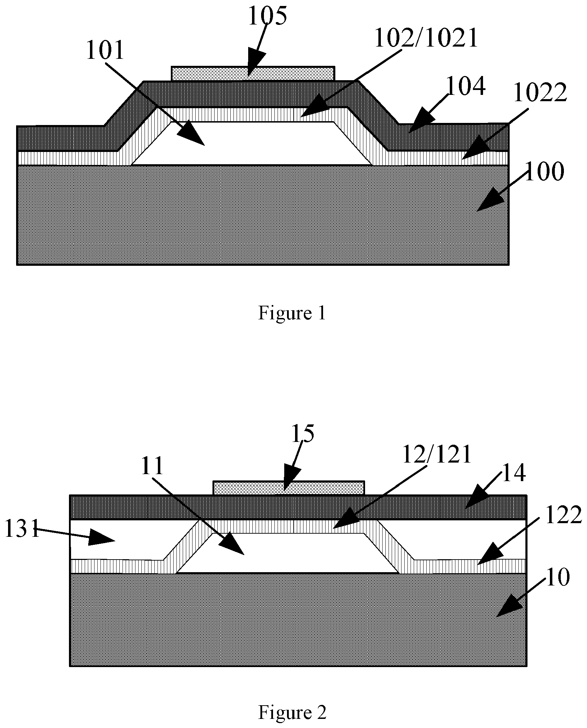

Reference is made to Figure 1, which is a schematic structural diagram of a resonator in conventional technology. The resonator comprises a substrate 100, a first electrode 102, a piezoelectric layer 104, and a second electrode 105. The substrate 100 comprises a first surface and a second surface which are opposite to each other. The first electrode 102 is located on the first surface. The first electrode 102 comprises a protruding portion 1021, which protrudes away from the first surface, and first flat portion(s) 1022, which are attached to the first surface. A cavity 101 is formed between the protruding portion 1021 and the first surface. The piezoelectric layer 104 is located at a side of the first electrode 102 away from the substrate 100. The second electrode 105 is located at a side of the piezoelectric layer 104 away from the first electrode. The piezoelectric layer 104 is grown directly on a surface of the first electrode 102, and hence its surface is conformed to a surface of the first electrode 102. That is, the surface of piezoelectric layer 104 follows fluctuations on the surface of the first electrode 102.

In conventional technology, the piezoelectric layer is subject to a large morphological change at an edge of the cavity since the cavity protrudes upwards in shape. Hence, there are a lot of growth defects and a large stress in the piezoelectric layer in such region, and thereby a variation of the stress is large throughout the entire wafer. Since the stress in a piezoelectric material has a direct impact on its effective piezoelectric coupling coefficient, the large variation in stress results in a poor piezoelectric performance of the entire piezoelectric layer, and thus reduces a yield of devices. In addition, the devices have poor mechanical stability under a thermal shock, and are more likely break at the edge of the cavity.

In view of the above, a resonator is provided according to an embodiment of the present disclosure. The resonator comprises a substrate, a first electrode, a piezoelectric layer, and a second electrode. The substrate comprises a first surface and a second surface which are opposite to each other. The first electrode is located on the first surface, and comprises a first protruding portion protruding away from the first surface and a first flat portion attached on the first surface. A cavity is formed between the first protruding portion and the first surface. A piezoelectric layer is located on a side of the first electrode away from the substrate, and extends in parallel with the first surface. A second electrode is located at a side of the piezoelectric layer away from the first electrode.

Where, the piezoelectric layer is parallel or nearly parallel to the first surface of the substrate, which is of a small local deformation or almost no deformation. Especially, at the edge of the cavity, the shape change of the piezoelectric layer is small, resulting in a small growth defect at the edge of the cavity and a small stress variation range of the piezoelectric layer on the whole wafer, to improve the consistency of the piezoelectric performance of the piezoelectric layer. In addition, due to the small deformation of the entire piezoelectric layer, the stability of the mechanical structure of the device is improved in the thermal shock environment. In other words, it is less likely to be broken when encountering external impacts, especially at the edge of the cavity, which lower the risk of breakage significantly.

In order to clarify the above objectives, features, and advantages of the present disclosure, hereinafter the present disclosure is further illustrated in conjunction with the drawings and specific implementations.

Reference is made to Figure 2, which is a schematic structural diagram of a resonator according to an embodiment of the present disclosure. As shown in Figure 2, the resonator comprises a substrate 10, a first electrode 12, a piezoelectric layer 14, and a second electrode 15. The substrate 10 comprises a first surface and a second surface which are opposite to each other. The first electrode 12 is located on the first surface. The first electrode 12 comprises a first protruding portion 121 protruding away from the first surface and first flat portion(s) 122 attached on the first surface. A cavity 11 is formed between the first protruding portion 121 and the first surface. A piezoelectric layer 14 is located at a side of the first electrode 12 away from the substrate 10. The piezoelectric layer 14 extends in parallel with the first surface. The second electrode 15 is located at a side of the piezoelectric layer 14 away from the first electrode 12.

In a specific embodiment, the piezoelectric layer 14 extending in parallel with the first surface refers to that the piezoelectric layer 14 extends in parallel or substantially parallel with the substrate 10. The piezoelectric layer 14 being parallel or substantially parallel with the substrate 10 renders local deformation throughout the entire piezoelectric layer 14 small. Hence, there are few growth defects due to the deformation, which improves a quality of the grown piezoelectric layer 14 and improves a quality (Q) factor. In addition, little deformation in the piezoelectric layer 14 further renders a change in stress in the piezoelectric layer 14 small. Hence, no region in the piezoelectric layer 14 is subject to large stress variation, and a piezoelectric performance is highly consistent throughout the piezoelectric layer 14, which leads to a high yield of the resonators. Moreover, the horizontal piezoelectric layer 14 can further improve a power tolerance of devices.

Herein first gap(s) 131 may be formed between the first flat portion(s) 122 of the first electrode 12 and the horizontal piezoelectric layer 14. The first gap 131 separates the piezoelectric layer 14 from the first flat portion 122 as well as from the first surface of the substrate 10. Thereby, the piezoelectric layer 14 is kept to be horizontal and extends in parallel with the first surface of the substrate 10.

In comparison with a horizontal first electrode, the first electrode 12 around the first gaps 131 comprises the first protruding portion 121, the first flat portion, 122 and an intermedia portion between the two. Due to a large variation in the shape, the first electrode 12 is capable to reflect acoustic waves in a transverse mode can be reflected, and hence reduce a loss in acoustic energy. Moreover, acoustic impedance of a material of the first gap 131 is different from that of a material of the first electrode 12, that is, there is acoustic impedance mismatch at the interface between the first gap 131 and the first electrode 12. Therefore, transverse waves can be suppressed, and the loss of the acoustic energy loss is further reduced, which improves the quality factor (Q) of the resonator.

The intermediate portion between the first protruding portion 121 and the first flat portion 122 of the first electrode 12 may be inclined, and the first gap 131 is located at a side of such inclined portion of the first electrode 12. The inclined shape is capable to reflect the transverse waves better. In addition, the first gap 131 separates the first electrode 12 and the piezoelectric layer 14 in a vertical direction above the substrate 10. Since an overlap among the first electrode 12, the piezoelectric layer 14, and the second electrode 15 above the substrate introduces parasitic oscillation, the first gap 131 can reduce such parasitic oscillation, especially in case of multiple connected resonators. Hence, an overall performance of a filter device can be improved.

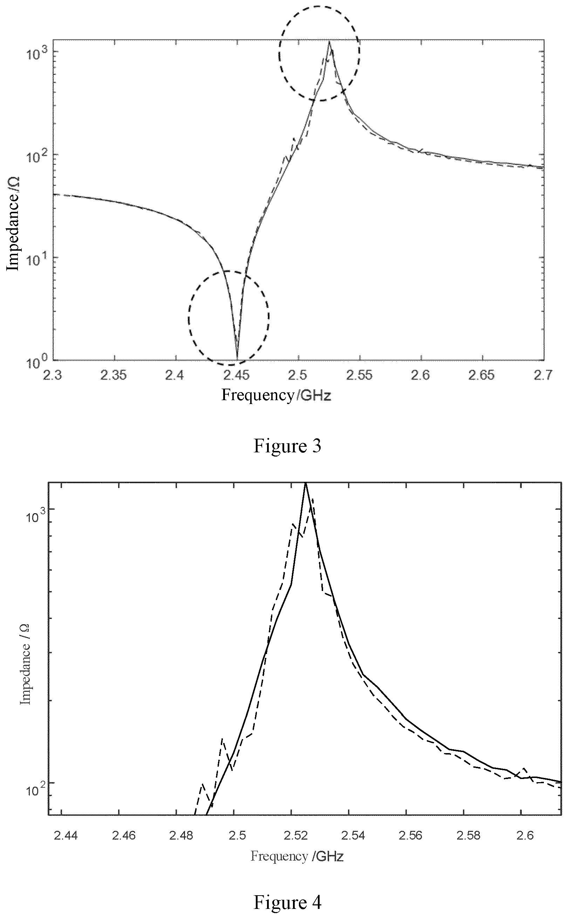

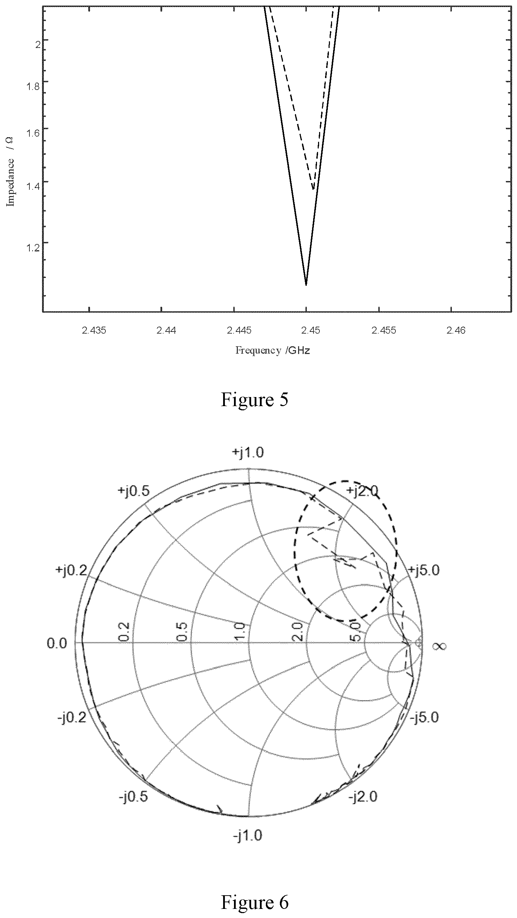

Reference is made to Figure 3 to Figure5, which are graphs of an impedance of a resonator versus a frequency according to an embodiment of the present disclosure. Figure 4 is a partial enlarged view of a region indicated by an upper dashed circle in Figure 3, and Figure 5 is a partial enlarged view of a region indicated by a lower dashed circle in Figure 3. The solid lines represent the impedance corresponding to the resonator, as shown in Figure 2, versus the frequency. The dashed lines represent the impedance corresponding to the resonator, as shown in Figure 1, versus the frequency.

As shown in Figure 4, a maximum of series impedance Rs of the resonator as shown in Figure 2 increases to 1250Ω, as indicated by the solid line, on a basis of 1100Ω as indicated by the dashed line. An increase in series impedance Rs of the resonator indicates an increase in series quality factor Q of the resonator.

As shown in Figure 5, a minimum value of parallel impedance Rp of the resonator as shown in Figure 2 drops to 1.1Ω, as indicated by the solid line, on a basis of 1.5Ω as indicated by the dashed line. A drop in parallel impedance Rp of the resonator indicates an increase in parallel quality factor Qp of the resonator.

In comparison with a structure of resonators in conventional technology, the structure of the resonator provided herein can further suppress parasitic oscillations through the first gaps 131, which is indicated in Figure 6.

Reference is made to Figure 6, which is a Smith chart of a resonator according to an embodiment of the present disclosure. The solid line in the Smith chart corresponds to the resonator as shown in Figure 2, and the dashed line in the Smith chart corresponds to the resonator as shown in Figure 1. The more a curve in the Smith chart deviates from the outermost circle, the stronger the parasitic resonance is. As indicated by the dashed circle in Figure 6, the dashed line deviates from the outermost circle much more than the solid line, which indicates that the parasitic oscillation of the resonator provided herein is significantly suppressed, especially for a parasitic mode at 2.5 GHz.

In the foregoing embodiments, the first gap 131 may be an air gap, or may be filled with a dielectric material.

In a specific embodiment, the dielectric material filled in the first gap 131 is a material having a low dielectric loss, such as SiO₂, SiC , PI (polyimide), aerosol, SiO₂ doped with carbon (C), SiLK dielectric Resin, or benzocyclobutene (BCB). Filling the dielectric material into the first gap 131 can not only improve the aforementioned electrical performances, but also provide a better support for the piezoelectric layer 14.

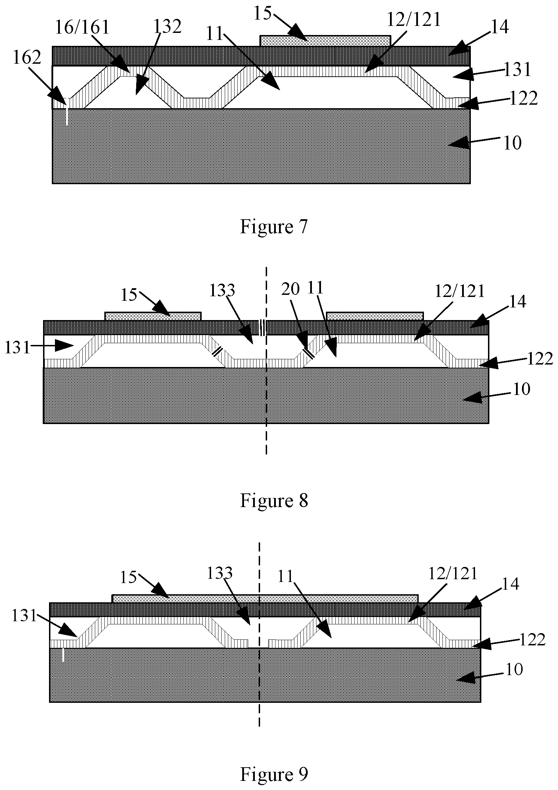

As shown in Figure 7, a supporting structure 16 may be provided in the resonator to further improve flatness of the piezoelectric layer 14. Thereby, the piezoelectric layer 14 is kept to be horizontal above the substrate 10 throughout an entire wafer, which ensures flatness of the piezoelectric layer 14.

Reference is made to Figure 7, which is a schematic structural diagram of a resonator according to another embodiment of the present disclosure. A side of the first flat portion(s) 122 away from the first protruding portion 121 is connected with the respective supporting structure 16. An upper surface of the supporting structure 16 and an upper surface of the protruding portion are in a same plane. Since the piezoelectric layer 14 is supported by the supporting structure 16 and the protruding portion, the piezoelectric layer 14 is kept to be horizontal between the first electrode 12 and the supporting structure 16.

Only one supporting structure 16 is depicted in Figure 7, and is located at left of the first electrode 12 as shown in the Figure 7. It is appreciated that one or more supporting structures 16 may be provided on requirement, and the one or more supporting structure 16 may be connected with the first flat portion(s) 122 located at one or more sides of the first protruding portion 121. In case of two or more supporting structures 16, the supporting structures 16 may be combined arbitrarily at two sides of the first flat portion 122 of the first electrode 12.

The supporting structure 16 may comprise a second protruding portion 161 protruding away from the first surface and a second flat portion 162 attached on the first surface. In some embodiments, there may be no second flat portion 162, and only the second protruding portion 161 is provided for supporting the piezoelectric layer 14. An upper surface of the second protruding portion 161 and an upper surface of the first protruding portion 121 are in a same plane, e.g., their heights with respect to the first surface are identical or substantially identical. Thereby, the supporting structure 16 is capable to support the piezoelectric layer 14, ensuring that the piezoelectric layer 14 extends in parallel with the substrate 10. Large deformation is suppressed or eliminated in a case that the piezoelectric layer 14 is too large, and hence the piezoelectric layer 14 are more consistence in piezoelectricity.

The foregoing supporting structure 16 may be made of a conductive material or a non-conductive material.

The conductive material may be at least one of: gold, ruthenium, molybdenum, aluminum, platinum, titanium, tungsten, palladium, chromium, or nickel. Among these materials, molybdenum material is one of the most commonly used materials due to its excellent electrical conductivity, a small dielectric loss and a low cost. In case of being made of the conductive material, the supporting structure 16 and the first electrode 12 may be made of the same material. Thereby, they can be prepared in the same process, which renders manufacturing less difficult and accelerates the manufacturing.

In case of being made of the conductive material, the supporting structure 16 may serve as a connecting structure besides a supporting component. The supporting structure 16 is in directly contact with the first electrode 12, so that the first electrode 12 can be electrically connected to another component via the supporting structure 16. In case of being made of the non-conductive material, the supporting structure 16 serves as only the supporting component, and should be prepared and formed separately from the first electrode 12.

Optionally, a second gap 132 may be formed between the second protruding portion 161 of the supporting structure 16 and the first surface. A dielectric material filled in the second gap 132 includes one or both of the air and a dielectric material having low acoustic impedance. The supporting structure 16 may be directly fabricated from a dielectric material as a non-conductive solid structure.

Hereinabove the structure of a single resonator is introduced. In practice, there may be a scenario in which multiple resonators are utilized in combination. Hence, a resonator assembly is provided according to an embodiment of the present disclosure. The resonator assembly comprises the resonators, each of which is according to any foregoing embodiment, and at least one of the resonators is connected to another one of the resonators.

The resonator assembly may comprise resonators, of any quantity, in the above embodiments on requirement, and is not limited to merely two resonators as shown in the drawings. Reference is made to Figure 8 to Figure 14, which are schematic structural diagrams of a resonator assembly according to different embodiments of the present disclosure.

A third gap 133 is formed between a portion of the piezoelectric layer 14, which is in a connecting between the two connected resonators, and the first electrode 12 and/or the first surface.

There are three connection modes. As shown in Figures 9, 11, 13, and 14, in a first mode, the first electrodes 12 of the two resonators are disconnected, and the third gap 133 is formed between the first surface, which is exposed due to the disconnection between the first electrodes 12, and the piezoelectric layer 14, which is shared by the two resonators. As shown in Figures 8, 10, and 12, in the second mode, the first electrodes 12 of the two resonators are connected as a whole, and the third gap 133 is formed between the first electrode 12 of the two resonators and the piezoelectric layer 14 shared by the two resonators. Further, in a third mode (not depicted), the above two modes are combined. That is, the first electrodes 12 of the two resonators are disconnected, and the third gap 133 is formed between the first surface, which is exposed due to the disconnection between the first electrodes 12, and the piezoelectric layer 14 shared by the two resonators. The first electrodes 12 of another two resonators are connected as a whole, and a corresponding third gap 133 is formed between the first electrode 12 of the other two resonators and the piezoelectric layer 14 shared by the other two resonators.

In an optional embodiment, the third gap 133 includes an air gap, a gap filled with a dielectric material, or a combination of the two.

Herein the first electrode 12 and the cavity 11 of a desired pattern may be formed based on a first sacrificial layer.

Both the first gap 131 and the third gap 133 may be both filled with air, may be both filled with a dielectric material, or may be both filled with a combination of air and a dielectric material. Alternatively, one of the two is filled with air while the other is filled with a dielectric material. As an example, both are filled with air, and formed through a same process. For example, spaces at which the first gap 131 and the third gap 133 are to be formed may be first provided with a second sacrificial layer 182, and then the second sacrificial layer 182 is released after the second electrode 15 is formed, so as to form the first gap 131 and the third gap 133 which are spatially connected. In a case that the first gap 131 and/or the third gap 133 are filled with the dielectric material, the sacrificial layer may be provided at the positions first, and the dielectric layer is filled after removing the sacrificial layer. Alternatively, the dielectric layer is directly provided and retained to form the gap(s).

As shown in Figure 8, a release hole 20 is provided at each of: the piezoelectric layer 14 above the third gap 133, and each intermediate portion of the first electrode 12 which is between the first protruding portion 121 and the first flat portions 122. The release holes 20 are configured to inject an etching reagent to form the cavity 11, the first gap 131, and the third gap 133.

The third gap 133 may be the air gap. In such case, when releasing the second sacrificial layer, the second sacrificial layer 182 corresponding spatially to the third gap 133 is first released via the release hole 20 penetrating the piezoelectric layer 14 above the third gap 133. In other words, the second sacrificial layer 182 in such region is removed through etching to form the third gap 133. After releasing the second sacrificial layer 182 in the region of the third gap 133, the first sacrificial layer filled in the space corresponding to the cavity 11 is released via the release hole 20 running through the first electrode 12. That is, the first sacrificial layer in such region is removed through etching to form the cavity 11.

The third gap 133 may be filled with the dielectric material. In such case, it is required to form a channel running through the dielectric material at a corresponding region of the third gap 133, so as to link the release hole 20 in the piezoelectric layer 14 with the release hole 20 in the first electrode 12. In such case, the etching reagent is not capable to remove the dielectric material in the region of the third gap 133, and is only used to remove the first sacrificial layer in the region of the cavity 11.

Herein the piezoelectric layer 14 is formed on a basis of the dielectric material or the second sacrificial layer 182 located in the third gap 133. Thereby, the piezoelectric layer 14 with good flatness as well as small deformation can be formed. The piezoelectric layer 14 is subject to small stress variation and has satisfactory piezoelectric consistency.

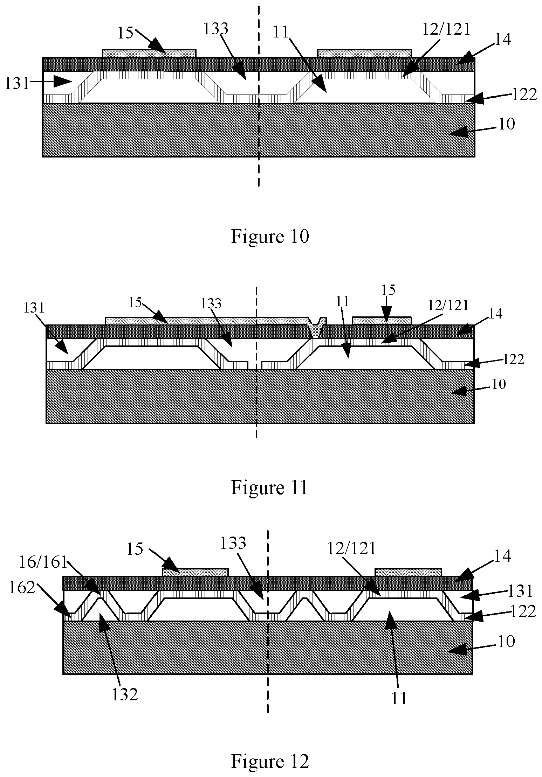

Herein the two resonators in the resonator assembly may be connected in following manners. As shown in Figure 9, the second electrode 15 of one resonator is connected to the second electrode 15 of the other resonator. Alternatively, as shown in Figure 8 and Figure 10, the first electrode 12 of one resonator is connected to the first electrode 12 of the other resonator. Alternatively, as shown in Figure 11, the first electrode 12 of one resonator is connected to the second electrode 15 of the other resonator.

Reference is made to Figure 9, which is a schematic structural diagram of a resonator assembly according to another embodiment of the present disclosure. In such structure, the first electrode 12 of one resonator is disconnected from the first electrode 12 of the other resonator, and the two second electrodes 15 are connected to each other.

Reference is made to Figure 10, which is a schematic structural diagram of a resonator assembly according to another embodiment of the present disclosure. In such structure, the first electrode 12 of one resonator is connected to the first electrode 12 of other resonator, and the two second electrodes 15 are disconnected.

Reference is made to Figure 11, which is a schematic structural diagram of a resonator assembly according to another embodiment of the present disclosure. In such structure, the first electrodes 12 of the two resonators are disconnected, the second electrodes 15 of the two resonators are disconnected, and the first electrode 12 of one resonator is connected to the second electrode 15 of the other resonator.

The two resonators as shown in each of Figure 8 to Figure 11 are connected without the supporting structure 16. In a case that there is the supporting structure 16 which is conductive, the two resonators may be connected in a manner as shown in Figure 12 to Figure 14. The first electrode 12 of one resonator is connected to the first electrode 12 of the other resonator via the supporting structure 16, or the second electrode 15 of one resonator is connected to the first electrode 12 of the other resonator via the supporting structure 16.

Reference is made to Figure 12, which is a schematic structural diagram of a resonator assembly according to another embodiment of the present disclosure. In such structure, the first electrode 12 of one resonator and the first electrode 12 of other resonator are connected via the supporting structure 16, and the second electrodes 15 of the two resonators are disconnected.

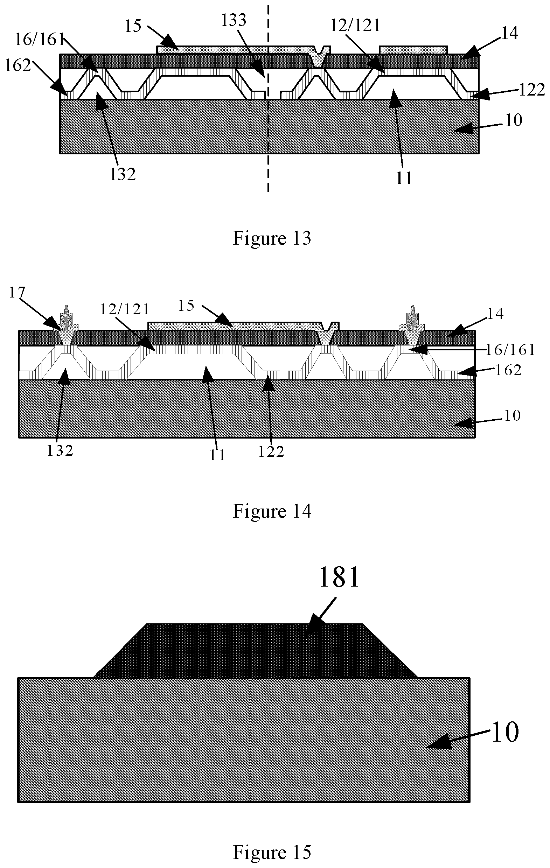

Reference is made to Figure 13, which is a schematic structural diagram of a resonator assembly according to another embodiment of the present disclosure. In such structure, the second electrode 15 of one resonator is connected to the first electrode 12 of the other resonator via the supporting structure 16, the first electrodes 12 of the two resonators are disconnected, and the second electrodes 15 of the two resonators are disconnected.

There may be resonators of any quantity in the resonator assembly. The resonators may include those are connected in series, those connected in parallel, or those connected in series-parallel.

Herein when the second electrode 15 of one resonator is connected to the first electrode 12 of the other resonator, the second electrode 15 of the one resonator may be connected to the first electrode 12 of the other resonator via a hole running through the piezoelectric layer 14 at the other resonator.

Hereinabove connection manners among the multiple resonators are illustrated. A manner of connecting the resonator assembly and another structure may be as shown in Figure 14.

Reference is made to Figure 14, which is a schematic structural diagram of a resonator assembly according to another embodiment of the present disclosure. In such structure, a terminal 17 for external connection, of the first electrode 12 or the second electrode 15 of the resonator, is connected to a bonding pad, a capacitor, or an inductor by using (i.e., at a top of) the supporting structure 16. Since the terminal 17 is connected to the bonding pad, the capacitor or the inductor via the supporting structure 16, a supporting function of the supporting structure 16 is further exploited to align the bonding pad or the like and the second electrode 15 in the same plane. Hence, it is convenient to fabricate the bonding pad, and it is ensured that the piezoelectric layer 14 is still horizontal at a position of the bonding pad, which further prevents morphological changes. In addition, damages to the piezoelectric layer 14 are reduced when the terminal 17 is connected to the bonding pad, the capacitor, or the inductor.

In the resonator assembly, the multiple resonators are located on the surface of the same substrate 10. The first electrodes 12 of different resonators are fabricated from the same conductive layer, the second electrodes 15 of different resonators are fabricated from the same conductive layer, and different resonators share the same piezoelectric layer 14. The piezoelectric layer 14 is located above the same substrate 10 and extends in parallel with the substrate 10, and is subject to little morphological change.

On a basis of the foregoing embodiments, a filter is further provided according to an embodiment of the present disclosure. The filter comprises the resonator or the resonator assembly according to any foregoing embodiment.

On a basis of the foregoing embodiments, an electronic device is further provided according to an embodiment of the present disclosure. The electronic device comprises the resonator or the resonator assembly according to any foregoing embodiment.

On a basis of the foregoing embodiments, a method for manufacturing a resonator is further provided according to an embodiment of the present disclosure. The method is for forming a structure in the foregoing embodiments. As an example, the structures of other embodiments may be manufactured with reference to such method. The manufacturing method may be as shown in Figure 15 to Figure 21, which illustrates a flow of manufacturing a resonator according to an embodiment of the present disclosure.

Reference is made to Figure 15. In step S100, a substrate 10 is provided. The substrate 10 comprises a first surface and a second surface. A first sacrificial layer 181 is formed on the substrate 10, and a region in which the first sacrificial layer 181 is located is for forming a cavity 11. In subsequent steps, the first sacrificial layer 181 is removed to form the cavity 11 after the second electrode 15 is formed.

The substrate 10 may be made of any one or any combinations of silicon, sapphire, polysilicon, silicon dioxide, gallium arsenide, spinel, glass or ceramics. Silicon is widely used due to its excellent properties. The first sacrificial layer 181 may be made of one or more of metals, such as Ge, Sb, Ti, Al, and Cu and the like, a silicon phosphate glass, and polymer.

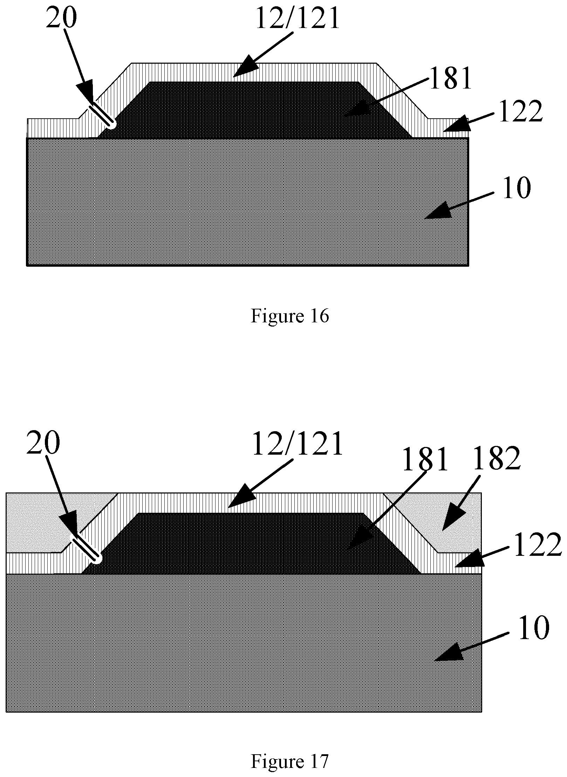

Reference is made to Figure 16. In step S110, a first electrode 12 is formed on the first surface. The first electrode 12 comprises a first protruding portion 121 protruding away from the first surface and first flat portion(s) 122 attached on the first surface. The cavity 11 is formed between the first protruding portion 121 and the first surface.

In the current step, the first sacrificial layer 181 is located between the first protruding portion 121 and the first surface, and the first sacrificial layer 181 would be removed after the second electrode 15 is formed. After the first sacrificial layer 181 is removed, an empty cavity 11 is formed, a shape and a dimension of the cavity 11 is determined by the first sacrificial layer 181.

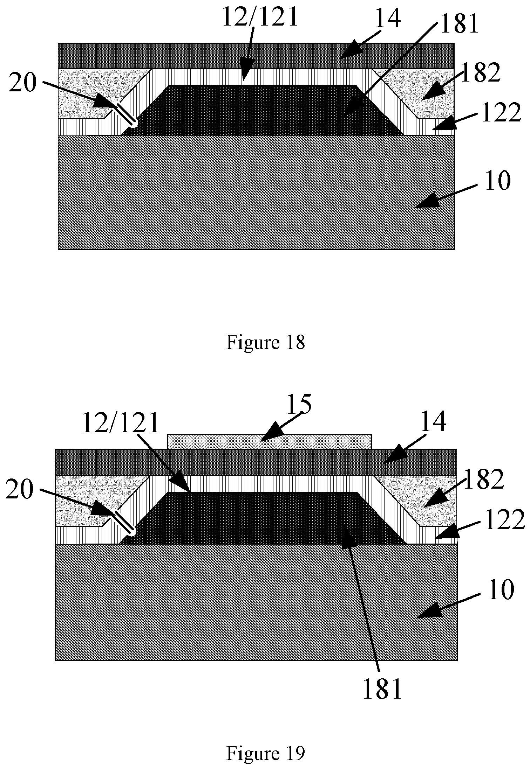

Reference is made to Figure 17 and 18. In step S120, a piezoelectric layer 14 is formed at a side of the first electrode 12 away from the substrate 10. The piezoelectric layer 14 extends in parallel with the first surface.

A sacrificial layer is required to be formed at a position at which a first gap 131 between the first flat portion 122 and the piezoelectric layer 14 is to be formed. As shown in Figure 17, the first electrode 12 needs to be processed before manufacturing the piezoelectric layer 14. That is, the first flat portion 122 is covered with the second sacrificial layer 182, and then the second electrode 15 is formed. As shown in Figure 18, the second sacrificial layer 182 is removed to form the first gap 131 after the second electrode 15 is formed. Alternatively, a dielectric layer is directly formed at the position at which the first gap 131 is to be formed, and the dielectric layer is retained.

Reference is made to Figure 19. In step 130, a second electrode 15 is formed at a side of the piezoelectric layer 14 away from the first electrode 12.

Before the piezoelectric layer 14 is formed, the second sacrificial layer 182 or the dielectric layer, of which an upper surface and an upper surface of the first protruding portion 121 are in a same plane, needs to be formed on the first flat portions 122. The sacrificial layer 182 is removed after the second electrode 15 is formed. In a case that the dielectric layer is formed for the first gap 131, it is not necessary to remove the dielectric layer.

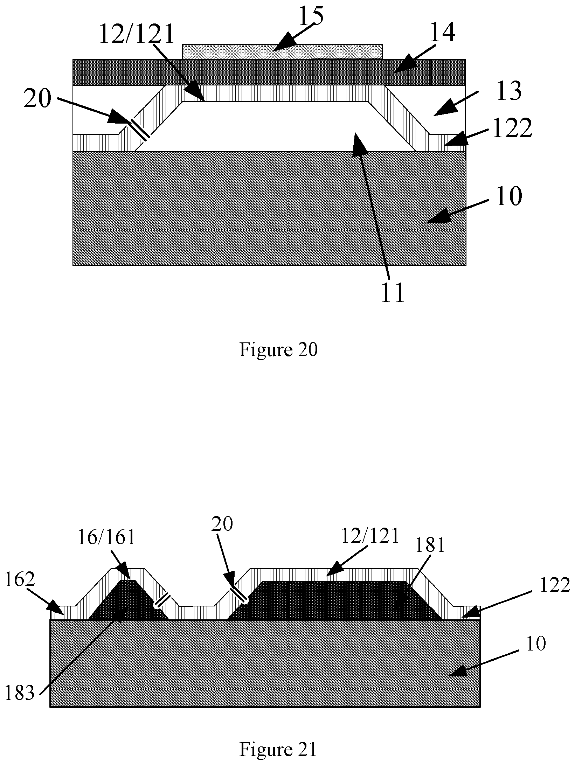

Reference is made to Figure 20. In step S140, the first sacrificial layer 181 and the second sacrificial layer 182 formed during the process of manufacturing the resonator are removed. The cavity 11 is formed after the first sacrificial layer 181 is removed, and first gap 131 is formed after the second sacrificial layer 182 is removed.

In the foregoing embodiments, the resonator may comprise a supporting structure 16, which may be manufactures as shown in Figure 21. The supporting structure 16 is formed at an "outer" side of the first electrode 12 with respect to the resonator. The supporting structure 16 comprises a second protruding portion 161 protruding away from the first surface and a second flat portion 162 attached on the first surface. An upper surface of the second protruding portion 161 and an upper surface of the first protruding portion 121 are in a same plane. A second gap 132 is formed between the second protruding portion 161 and the first surface.

Herein the second gap 132 is formed between the second protruding portion 161 of the supporting structure 16 and the first surface. Before manufacturing the supporting structure 16, a third sacrificial layer 183 is formed at a position at which the second gap 132 is to be formed. Then, the supporting structure 16 is formed on the third sacrificial layer 183. After the second electrode 15 is formed, the third sacrificial layer 183 is removed. Alternatively, a dielectric layer is directly formed at the position at which the second gap 132 is to be formed, and the supporting structure 16 is formed on the dielectric layer. It is not necessary to remove the dielectric layer under the supporting structure 16 through etching. The first sacrificial layer 181 and the third sacrificial layer 183 may be made of the same material. In such case, the same release agent may be used when releasing both sacrificial layers, which simplifies operation and reduces time consumption of manufacturing the resonator.

The supporting structure 16 may be manufactured in a same process as the first electrode 12, and the supporting structure 16 and the first electrode 12 may be fabricated as/from the same layer. Hence, no additional step is added when the supporting structure 16 is added to improve uniformity of the piezoelectric layer.

Each embodiment in this specification is described in a progressive, parallel, or progressive and parallel manner, and each embodiment places emphasis on the difference from other embodiments. Therefore, one embodiment can refer to other embodiments for the same or similar parts. Since manufacturing methods disclosed in the embodiments corresponds to the resonators disclosed in the embodiments, the description of the methods is simple, and reference may be made to the relevant part of the resonators.

It should be noted that in the description of the present disclosure, the figures and embodiments are illustrative rather than restrictive. Identical reference numbers identify the same structure throughout embodiments of the present disclosure. In addition, the drawings may exaggerate thicknesses of some layers, films, panels, regions, and the like to facilitate understanding and description. It should be further understood that when an element such as a layer, a film, a region, or a substrate is described to be "on" another element, it may be directly on the other element or there may be intermediate elements. In addition, "on" refers positioning an element above or beneath another element, which does not essentially mean positioning on an upper side of another element with respective to a direction of gravity.

The orientation or positional relationship indicated by the terms "upper", "lower", "top", "bottom", "inner", "outer", and the like are based on the orientation or positional relationship as shown in the drawings, and are only intended for facilitating describing the present disclosure and simplifying the descriptions, rather than indicating or implying that the concerning apparatus or element must have a specific orientation, or be constructed or operate in a specific orientation. Hence, they should not be construed as a limitation on the present disclosure. When a component is considered to be "connected" with another component, it may be directly connected to the other component or there may be an intermediate component.

It should be noted that, the relationship terms such as "first", "second" and the like are only used herein to distinguish one entity or operation from another, rather than to necessitate or imply that an actual relationship or order exists between the entities or operations. Furthermore, the terms such as "include", "comprise" or any other variants thereof means to be non-exclusive. Therefore, an article or a device including a series of elements include not only the disclosed elements but also other elements that are not clearly enumerated, or further include inherent elements of the article or the device. Unless expressively limited, the statement "including a..." does not exclude the case that other similar elements may exist in the article or the device other than enumerated elements.

According to the description of the disclosed embodiments, those skilled in the art can implement or use the present disclosure. Various modifications made to these embodiments may be obvious to those skilled in the art, and the general principle defined herein may be implemented in other embodiments without departing from the spirit or scope of the present disclosure. Therefore, the present disclosure is not limited to the embodiments described herein but conforms to a widest scope in accordance with principles and novel features disclosed in the present disclosure.

## Claims

1. A resonator, comprising:
a substrate, comprising a first surface and a second surface opposite to each other;
a first electrode, located on the first surface, wherein the first electrode comprises a first protruding portion protruding away from the first surface and a first flat portion attached on the first surface, and a cavity is formed between the first protruding portion and the first surface;
a piezoelectric layer, located at a side of the first electrode away from the substrate, wherein the piezoelectric layer extends in parallel with the first surface; and
a second electrode, located at a side of the piezoelectric layer away from the first electrode

2. The resonator according to claim 1, wherein a first gap is formed between the first flat portion and the piezoelectric layer.

3. The resonator according to claim 2, wherein the first gap comprises an air gap, or the first gap is filled with a dielectric material.

4. The resonator according to claim 1, wherein a side of the first flat portion away from the first protruding portion is physically connected to a supporting structure, and an upper surface of the supporting structure and an upper surface of the first protruding portion are in a same plane.

5. The resonator of claim 4, wherein the supporting structure comprises:
a second protruding portion protruding away from the first surface, and
a second flat portion attached on the first surface.

6. The resonator according to claim 4, wherein the supporting structure is made of a conductive material or a non-conductive material.

7. The resonator according to claim 4, wherein a second gap is formed between the second protruding portion and the first surface.

8. The resonator according to claim 7, wherein a dielectric material filled in the second gap comprises one or both of: air, and a dielectric having low acoustic impedance.

9. A resonator assembly, comprising:
a resonator and another resonator that are connected, wherein the resonator and the another resonator each is the resonator according to any one of claims 1 to 8.

10. The resonator assembly according to claim 9, wherein a third gap is formed between:
a portion of the piezoelectric layer, which is in a connection region between the resonator and the other resonator, and
one or both of the first electrode and the first surface.

11. The resonator assembly of claim 10, wherein the third gap comprises an air gap or is filled with a dielectric material.

12. The resonator assembly of claim 10, wherein a release hole is provided at each of:
the piezoelectric layer at the portion above the third gap, and
the first electrode at a portion between the first protruding portion and the first flat portion,
wherein the release hole is configured to inject an etching reagent to form the third gap or the cavity.

13. The resonator assembly according to claim 9, wherein:
the first electrode of the resonator and the first electrode of the another resonator are connected to each other;
the second electrode of the at least one resonator and the second electrode of the another resonator are connected; or
the first electrode of the at least one resonator and the second electrode of the another resonator are connected.

14. The resonator assembly according to claim 9, wherein:
the first electrode of the resonator and the first electrode of the another resonator are connected via the supporting structure, or
the second electrode of the resonator is connected to the first electrode of the another resonator via the supporting structure.

15. The resonator assembly according to claim 13 or 14, wherein the second electrode of the resonator is connected to the first electrode of the another resonator via a hole running through the piezoelectric layer of the other resonator.

16. The resonator assembly according to claim 14, wherein a terminal for external connection, for one or both of the first electrode and the second electrode of the resonator, is connected to a bonding pad, a capacitor, or an inductor via the supporting structure.

17. A filter, comprising:
the resonator according to any one of claims 1 to 8.

18. An electronic device, comprising:
the resonator according to any one of claims 1 to 8.

19. A method for manufacturing a resonator, comprising:
providing a substrate, which comprises a first surface and a second surface opposite to each other;
forming a first electrode which is on the first surface, wherein the first electrode comprises a first protruding portion protruding away from the first surface and a first flat portion attached on the first surface, and a cavity is formed between the first protruding portion and the first surface;
forming a piezoelectric layer which is at a side of the first electrode away from the substrate, wherein the piezoelectric layer extends in parallel with the first surface; and
forming a second electrode which is at a side of the piezoelectric layer away from the first electrode.

20. The method according to claim 19, further comprising:
forming a first sacrificial layer in a region in which the cavity is to be formed, and
removing the first sacrificial layer after forming the second electrode to form the cavity.

21. The method according to claim 19, wherein a first gap is formed between the first flat portion of the first electrode and the piezoelectric layer.

22. The method according to claim 21, wherein further comprising:
forming a second sacrificial layer in a region in which the first gap is to be formed, and removing the second sacrificial layer after forming the second electrode to form the first gap; or
forming a dielectric layer in the region in which the first gap is to be formed to form the first gap.

23. The method according to claim 19, wherein before forming the piezoelectric layer, the method further comprises:
forming a supporting structure at a side of the first flat portion away from the first protruding portion, wherein the supporting structure comprises a second protruding portion protruding away from the first surface and a second flat portion attached on the first surface, and an upper surface of the second protruding portion and an upper surface of the first protruding portion are in a same plane.

24. The method according to claim 23, wherein a second gap is formed between the second protruding portion and the first surface, and forming the supporting structure comprises:
forming a third sacrificial layer in a region in which the second gap is to be formed; forming the supporting structure on the third sacrificial layer; and removing the third sacrificial layer after forming the second electrode; or
forming a dielectric layer in a region in which the second gap is to be formed; and forming the supporting structure on the dielectric layer.

25. The method according to claim 23, wherein the supporting structure and the first electrode are simultaneously formed as a same layer or from a same layer.
